(19) **Europäisches Patentamt / European Patent Office / Office européen des brevets**

(11) **EP 1 493 228 B1**

(12) **FASCICULE DE BREVET EUROPEEN**

(45) Date de publication et mention de la délivrance du brevet:
**08.10.2008 Bulletin 2008/41**

(51) Int Cl.:
**H03H 11/34** *(2006.01)*   **H03H 11/04** *(2006.01)*
**H04B 1/58** *(2006.01)*

(21) Numéro de dépôt: **03730176.9**

(22) Date de dépôt: **07.04.2003**

(86) Numéro de dépôt international:
**PCT/EP2003/050093**

(87) Numéro de publication internationale:
**WO 2003/085829 (16.10.2003 Gazette 2003/42)**

(54) **CIRCUIT INTEGRE A APPLICATION SPECIFIQUE POUR DISPOSITIF DE FILTRAGE PASSE-BAS DESTINE AU DECOUPLAGE DES VOIES XDSL**

ANWENDUNGSSPEZIFISCHE INTEGRIERTE SCHALTUNG FÜR EINE ZUM ENTKOPPELN VON XDSL-KANÄLEN VERWENDETE TIEFPASSFILTEREINRICHTUNG

APPLICATION-SPECIFIC INTEGRATED CIRCUIT FOR A LOW-PASS FILTERING DEVICE USED FOR DECOUPLING XDSL CHANNELS

(84) Etats contractants désignés:
**AT BE BG CH CY CZ DE DK EE ES FI FR GB GR HU IE IT LI LU MC NL PT RO SE SI SK TR**

(30) Priorité: **05.04.2002 FR 0204295**

(43) Date de publication de la demande:
**05.01.2005 Bulletin 2005/01**

(73) Titulaire: **Laboratoire Europeen ADSL**
**92400 Courbevoie (FR)**

(72) Inventeurs:
• **KRUMMENACHER, François**
 **CH-1007 Lausanne (CH)**
• **DE RAAD, Christina**
 **CH-1007 Lausanne (CH)**
• **NALLATAMBY, Guy-Michel**
 **35577 Cesson Sevigne Cedex (FR)**
• **DEDIEU, Hervé**
 **F-35500 Vitré (FR)**

(74) Mandataire: **Camus, Olivier Jean-Claude**
**SCHMIT CHRETIEN**
**8, place du Ponceau**
**95000 Cergy (FR)**

(56) Documents cités:
**EP-A- 0 942 578**   **EP-A- 1 005 209**

**Description**

La présente invention a pour objet un circuit intégré à application spécifique, ou ASIC (Application Specific Integrated Circuit en anglais) pour un dispositif de filtrage passe-bas destiné au découplage des voies xDSL. Elle est notamment destinée à être incorporée dans un dispositif séparateur de signaux voix-données pour une transmission sur des voies xDSL. Elle propose une architecture particulière de circuit intégré à application spécifique permettant notamment d'améliorer la sélectivité du dispositif de filtrage dans lequel elle est disposée.

Le domaine de l'invention est, d'une façon générale, celui des technologies dites xDSL. Dans ces technologies, on trouve par exemple la technologie ADSL (pour Asymmetric Digital Subscriber Line, en anglais, pour ligne d'abonné numérique à débit asymétrique), la technologie VDSL (pour Very-high-data rate Digital Subscriber Line, pour ligne d'abonné numérique à très haut débit), ou encore les technologies HDSL ou SDSL. L'invention sera plus particulièrement décrite, à titre d'exemple, dans le cadre de l'ADSL. Elle peut cependant également être utilisée avec les autres technologies xDSL. Ces technologies sont essentiellement mises en oeuvre sur des boucles locales des réseaux de téléphonie existant, la boucle locale étant constituée par les intermédiaires du réseau entre un central téléphonique et un poste d'abonné. Un des objectifs essentiels de ces technologies est de rendre possible, sur les boucles locales des anciens réseaux de téléphonie, la transmission simultanée de différents types de signaux : d'une part, les signaux relatifs aux conversations téléphoniques habituelles entre deux abonnés, ces premiers signaux comprenant des signaux relatifs à la voix et des signaux de signalisation, et d'autre part, des signaux relatifs à des données, typiquement des informations échangées entre un abonné et un site accessible via le réseau Internet.

Pour des transmissions selon ces technologies, on utilise donc la paire de fils de cuivre qui arrive chez l'abonné, et qui constitue depuis longtemps la ligne téléphonique, ou boucle d'abonné, à laquelle sont raccordés les différents combinés téléphoniques, également désignés comme terminaux bande étroite, de l'utilisateur des réseaux analogiques traditionnels dits POTS (pour Plain Old Telephone System - système ancien de télécommunications) ou des réseaux numériques traditionnels dits ISDN (ou RNIS - réseau numérique à intégration de services). Cette paire de fils de cuivre est le plus souvent torsadée et comporte une gaine isolante en polyéthylène.

Sur cette paire de fils de cuivre, on transmet donc à la fois :

- en bande de base, des signaux analogiques non modulés correspondant aux réseaux POTS, ou des signaux numériques correspondant aux réseaux ISDN. Les signaux analogiques en bande de base sont de fréquence typiquement 0 à 4 kHz, ou 0 à 16 KHz si on tient compte des signaux de signalisation. Les signaux numériques en bande de base sont dans des fréquences de 0 à 94 KHz. En pratique, la bande de base est destinée à une transmission en mode circuit;
- en bande haute fréquence, d'autres signaux, numériques et modulés, qui correspondent par exemple aux informations échangées avec le réseau Internet. La bande haute s'étale du dessus de la bande de base téléphonique jusqu'à 1 MHz environ. En pratique la bande haute fréquence s'étale de 26 KHz à 1,1MHz si la paire de fils de cuivre sert en bande de base pour une transmission analogique POTS, et de 138 KHz à 1,1 MHz si elle sert pour une transmission numérique. Elle est normalement destinée à une transmission permanente, en mode paquets principalement, c'est à dire qu'une communication permanente est établie entre l'abonné et le central téléphonique. On est ainsi dispensé des opérations classiques intervenant lors d'une connexion avec accès par ligne commutée, qui est une méthode de connexion temporaire à un réseau informatique consistant à utiliser un modem, un logiciel de connexion et le réseau téléphonique commuté comme moyen de mise en communication de son propre ordinateur et d'un autre ordinateur du réseau.

Bien que la bande de base puisse être utilisée, notamment avec des modems de préférence numériques, pour transmettre des données, et que la bande haute fréquence puisse servir à assurer des communications phoniques dans le cadre de communications dites communications téléphoniques sur Internet, on considérera, de façon schématique, et dans un souci de simplification des explications, que la bande de base est utilisée pour la transmission d'un premier type de signaux, essentiellement des paroles, correspondant à des communications phoniques, et que la bande haute fréquence sert pour la transmission d'un deuxième type de signaux, essentiellement des données, relatives notamment à la consultation de sites Internet.

La bande de base n'est capable que d'un faible débit (actuellement 56 Kbits/s pour les modems analogiques et 64 Kbits/s pour les modems numériques) alors que la bande haute fréquence est susceptible de présenter un haut débit (pouvant avoisiner 10 Mbits/s).

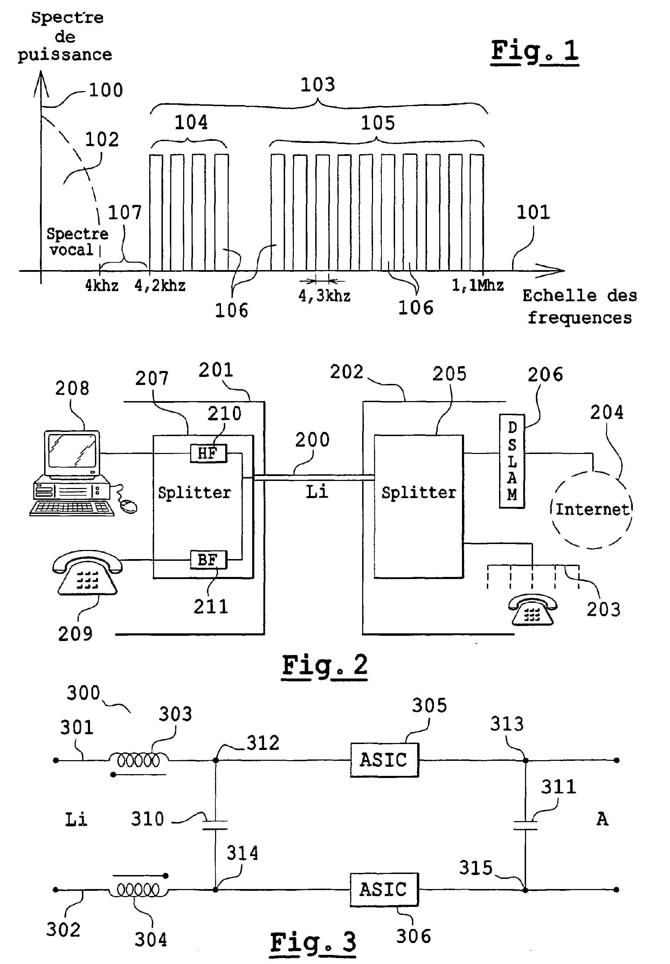

La figure 1 illustre l'exploitation de la bande de fréquence en distribution ADSL. L'axe des ordonnées 100 échelonne la puissance des signaux émis, et l'axe des abscisses 101 donne l'échelle des fréquences. Les puissances émises sont représentées de façon équirépartie dans un but de simplification. On retrouve le spectre vocal 102 s'étendant de 0 à 4 kHz, et le spectre 103 utilisé pour la transmission de données selon la technologie ADSL, ce dernier s'étendant d'environ 30 kHz à 1,1 MHz. Le spectre 103 est divisé en deux parties principales : une première bande de fréquence 104 correspondant au spectre utilisé pour les données montantes (de l'abonné vers le central) et une deuxième bande de fréquence 105 correspondant au spectre utilisé pour les données descendantes (du central vers l'abonné). La deuxième bande de fréquence 105 est plus large que la première bande de fréquence 104 car les données montantes, qui correspondent le plus souvent à des requêtes émises par un abonné, sont le plus souvent moins nombreuses que les données descendantes, qui peuvent correspondre au téléchargement de gros fichiers, des images par exemple.

L'utilisation d'une ligne dite ADSL nécessite donc de séparer la bande de base, basse fréquence, de la bande haute fréquence. La figure 2 illustre schématiquement ces séparations au niveau d'une boucle locale de communication. Sur cette figure, on a représenté une ligne téléphonique usuelle 200, ou boucle d'abonné, composée de deux fils en cuivre, qui assure la liaison entre un abonné 201, qui dispose d'une installation privative, et un central téléphonique 202.

Le central téléphonique 202 assure la connexion à un réseau de téléphonie classique 203 et à un réseau de type Internet 204. Afin de dissocier les signaux destinés au réseau téléphonique 203 et au réseau Internet 204, un premier dispositif 205 séparateur de signaux voix-données, également appelé filtre à aiguillage ou splitter, est utilisé. D'une façon générale, un splitter est un dispositif électronique associé à un modem ADSL qui permet de séparer les signaux de la voix des signaux de données et de les acheminer sur deux voies différentes. Le splitter 205 sera désigné par la suite comme splitter central.

Le splitter central 205 est le plus souvent incorporé dans une carte de splitters, cette carte pouvant comporter jusqu'à quelques dizaines de splitters centraux. Il a pour fonction de séparer les signaux de données, qui sont orientés vers le réseau Internet 204, et les signaux de voix, qui sont orientés vers les réseaux de téléphonie classiques 203. Une autre fonction du splitter central 205 est de multiplexer les signaux de voix, émis par les réseaux de téléphonie classiques 203, et les signaux émis par un multiplexeur d'accès 206 ultérieurement détaillé, afin de les acheminer sur la même paire torsadée 200. En théorie, on trouve dans le splitter central 205 un filtre basse fréquence et un filtre haute fréquence, qui laissent passer respectivement les signaux phoniques et les signaux ADSL. La conception du splitter central 205 doit être telle que les services téléphoniques classiques des réseaux POTS et/ou ISDN ne soient pas perturbés par la présence des signaux ADSL, et que le flux de données des signaux ADSL ne soit pas affecté par certaines opérations classiques observables sur ces réseaux, notamment les opérations de décroché/raccroché.

Les données destinées au - ou provenant du - réseau Internet 204 transitent par un multiplexeur d'accès DSL 206, appelé DSLAM, qui est relié au splitter central 205. Un DSLAM (pour Digital Subscriber Line Access Multiplexer en anglais) est un multiplexeur d'accès, conçu spécialement pour les équipements DSL, habituellement situé dans les locaux des centraux téléphoniques, qui transmet les signaux sur Internet en utilisant une technique de multiplexage temporel.

Du côté de l'abonné 201, on trouve également un splitter 207 relié à la ligne téléphonique 200. Le splitter 207 est appelé splitter maître. Quand plusieurs téléphones sont connectés à la même ligne, chacun d'entre eux doit être protégé par un filtre passe-bas. Dans ce dernier cas, on utilise des filtres de protections d'ordre 2 ou 3 à faible coût. La simplicité de réalisation et la compacité de ces filtres les a consacrés sous l'appellation micro-filtres. Le splitter maître 207 a aussi pour fonction de séparer les signaux de données, qui sont orientés vers un ordinateur personnel 208 associé à un modem ADSL, et les signaux de voix, qui sont orientés vers des combinés téléphoniques classiques 209. En théorie, on trouve également dans le splitter maître 207 un filtre basse fréquence et un filtre haute fréquence, qui laissent passer respectivement les signaux phoniques et les signaux ADSL. La conception du splitter maître 207 doit être telle que, comme pour le splitter central 205, il doit pouvoir éviter tout phénomène d'interférence ou d'altération, pour chaque type de signaux, qui pourrait être causé par l'autre type de signaux.

Dans la pratique, le filtre basse fréquence du splitter et le filtre haute fréquence sont séparés et distincts. Sur la figure, ces filtres sont représentés uniquement du côté abonné. Le filtre haute fréquence 210, c'est à dire le filtre qui laisse passer les signaux de données et uniquement ceux-là, est disposé entre la ligne téléphonique 200 et le DSLAM 206 (côté central téléphonique) et entre la ligne téléphonique 200 et l'ordinateur personnel 208 (côté abonné). Le filtre haute fréquence 210 peut être incorporé, partiellement ou totalement, dans un modem ADSL. Le filtre basse fréquence 211 est, pour sa part, disposé entre la ligne téléphonique 200 et le réseau de téléphonie classique 203 (côté central téléphonique) et entre la ligne téléphonique 200 et les combinés téléphoniques classiques 209 (côté abonné).

Chaque filtre sert à isoler l'installation qu'il relie des signaux destinés à l'autre installation. Notamment, le filtre basse fréquence 211 sert à empêcher que les signaux phoniques soient perturbés par les signaux de données. Par abus de langage, on appelle de tels filtres basse fréquence également des "splitters" dans la mesure où le filtre passe-haut nécessaire au modem est intégré dans ce même modem. De tels filtres dénommés souvent micro-filtres sont incorporés dans des dispositifs de filtrage objet de l'invention.

L'installation des filtres, et notamment des filtres passe-bas, doit satisfaire à plusieurs contraintes :

- le respect de valeurs d'impédances d'entrée et de sortie imposées. Afin que la puissance transmise par la ligne téléphonique le soit avec le meilleur rendement possible, les lignes téléphoniques doivent être caractérisées, en entrée et en sortie, par une impédance ayant une valeur aussi proche que possible de l'impédance complexe caractéristique de la ligne téléphonique. L'introduction de filtres sur la ligne téléphonique doit respecter ce principe.

On appelle Zc une telle impédance caractéristique. Dans la pratique Zc est une valeur imposée par une norme, la norme en question pouvant être différente d'un pays à l'autre, même si les impédances concernées ont des valeurs sensiblement comparables. On trouve ainsi notamment l'impédance européenne harmonisée, l'impédance anglaise, l'impédance allemande, et deux impédances américaines dites à 600 ohms et 900 ohms respectivement. Les différences entre ces impédances dépendent notamment du diamètre des fils de cuivre utilisés, de l'isolant et du pas des torsades.

- le facteur dit d'affaiblissement d'insertion, ou ILF (pour Insertion Loss Factor en anglais), qui mesure un affaiblissement de puissance d'une voie de transmission lorsqu'il s'y trouve des montages en pont, des filtres, des égaliseurs ou d'autres montages. Dans le cas présent, ce facteur mesure la perte de transmission occasionnée dans le circuit par la mise en place d'un filtre, entre une situation où le filtre n'est pas présent et une situation où il est mis en place ; selon les différentes normes en vigueur, lorsque l'impédance caractéristique est purement résistive, la perte doit être inférieure à 0,3 dB ; pour les impédances complexes, la perte d'insertion doit être inférieure à 1 dB.
- le facteur dit d'affaiblissement de réflexion, ou RLF (pour Return Loss en anglais), qui est une mesure liée à la puissance de signal réfléchi par rapport à la puissance de signal transmissible. Il s'exprime par la formule suivante :

$$RLF = 20 \log 10 \ abs(((Zin(w)+Zc(w)) / ((Zin(w)-Zc(w))),$$

où Zin(w) mesure l'impédance d'entrée du dispositif dont on veut mesurer le RLF, et où Zc(w) est l'impédance d'une charge de référence. On voit clairement que le Return Loss correspond à une mesure d'adaptation d'impédance. Lorsque l'adaptation est parfaite (Zin(w)=Zc(w)), le Return Loss tend vers l'infini. Dans les normes, l'affaiblissement de réflexion pour un filtre basse fréquence doit être supérieur à environ 18 dB dans la bande de base utile (300 - 3400 Hz en réseau POTS, et 300 - 94000 Hz en réseau ISDN).

Pour tenter de satisfaire à toutes ces contraintes, il a été imaginé différents type de filtres basse fréquence. Une des solutions préférées de l'état de la technique est l'utilisation de filtres elliptiques, également appelés filtres de Cauer, qui sont connus de l'homme du métier. Cependant, de telles structures de filtres ne sont pas entièrement satisfaisantes. Elles présentent de nombreux inconvénients et/ou désavantages :

- tout d'abord, la structure des filtres elliptiques est composée des composants passifs non dissipatifs. Or la nature complexe des impédances caractéristiques de ligne, dont la partie imaginaire n'est plus négligeable avec les technologies xDSL, impose, pour obtenir un filtre optimal, d'introduire des correcteurs constitués de quelques résistances et/ou capacités négatives. De tels correcteurs doivent donc faire appel à des composants actifs qui ne sont pas prévus dans ces filtres ;
- les exigences des différentes normes en terme de niveau de réjection des signaux ADSL et de return loss impliquent la présence d'au moins quatre transformateurs au sein du filtre basse fréquence. Ceci a pour conséquence d'une part un coût non négligeable dans la réalisation des filtres, et, d'autre part, du fait de la grande variabilité du marché de la ferrite, des périodes de pénurie parfois importantes.
- du fait du nombre important de bobines utilisées dans les filtres de l'état de la technique, l'espace occupé par chaque splitter est de l'ordre de 15 à 20 cm². Cet encombrement n'est pas négligeable, essentiellement du côté central téléphonique où de nombreux splitters sont montés ensemble sur une même carte.
- les performances des filtres passifs peuvent varier sensiblement d'un filtre à l'autre du fait de la tolérance des inductances utilisées, qui est de l'ordre de plus ou moins 7%.

Afin de résoudre l'ensemble de ces problèmes, le déposant a proposé un dispositif de filtrage passe-bas faisant notamment intervenir des circuits intégrés de type ASIC (Application Specific Integrated Circuit en anglais pour circuit intégré à application spécifique), qui sont disposés en série, sur chacune des deux lignes de transmission composant la ligne téléphonique. La présence d'un ASIC sur chacune des lignes de transmission est nécessaire afin de respecter la symétrie des lignes téléphoniques. Les deux ASIC présentent une structure similaire, cette structure étant un objet de la présente invention. Quelques éléments passifs sont toujours présents dans le dispositif de filtrage basse fréquence incorporant les ASIC.

Un schéma de principe d'un dispositif de filtrage basse fréquence 300, dans lequel on peut incorporer un circuit intégré à application spécifique du type de celui dont l'architecture est un objet de la présente invention, est représenté à la figure 3.Le dispositif 300 est décrit dans le cas où il est placé du côté abonné A de la ligne. Il pourrait cependant être disposé du côté central téléphonique. Sur cette figure, on retrouve une ligne téléphonique classique Li, composée d'une première ligne de transmission 301, appelée brin A ou ligne TIP, et d'une deuxième ligne de transmission 302, appelée brin B ou ligne RING. Sur chaque ligne de transmission 301 et 302, on dispose une inductance, respectivement 303 et 304. Ces deux inductances ont, pour des raisons de symétrie de la ligne téléphonique, la même valeur. Typiquement, cette valeur est de l'ordre de 17,5 mH (milliHenry). Sur chaque ligne de transmission, on dispose ensuite, en série avec l'inductance 303, respectivement 304, un composant actif de type ASIC 305, respectivement 306. Les deux ASIC 305 et 306 doivent avoir, pour des raisons de symétrie de la ligne téléphonique Li, des structures identiques.

Dans le dispositif de filtrage passe-bas 300, les ASIC constituant la partie active sont associés à une partie passive. Cette partie passive comprend notamment les inductances 303 et 304. Elle peut également comporter :

- une première capacité 310 qui relie les deux lignes de transmission 301 et 302 au niveau de points de connexion 312 et 314, situés respectivement entre la bobine 303 et l'ASIC 305, et entre la bobine 304 et l'ASIC 306. Cette première capacité 310 permet essentiellement de compléter la partie passive du dispositif selon l'invention, qui, associée aux inductances 303 et 304, constitue alors un filtre passif d'ordre 2. La valeur de cette première capacité 310 est typiquement de 27 nF.
- une deuxième capacité 311 qui relie les deux lignes de transmission 301 et 302 au niveau de points de connexion 313 et 315 situés respectivement sur la première ligne de transmission 301 et sur la deuxième ligne de transmission 302, en sortie du filtre 300, du côté de l'abonné A. La deuxième capacité 311 sert essentiellement à filtrer un signal de bruit haute fréquence qui pourrait être généré par chaque ASIC. Elle contribue également au filtrage des signaux haute fréquence transmis selon les technologies xDSL. La valeur de cette deuxième capacité 311 est typiquement de 56 nF.

Un dispositif similaire est connu p. ex. du document EP 0 942 578 A2.

Un des problèmes essentiels d'un dispositif de filtrage tel que décrit à la figure 3 est que les ASIC doivent être alimentés en énergie. On leur attribue donc une source d'énergie externe appropriée pour leur fonctionnement. Mais l'installation d'un dispositif de filtrage devient alors coûteuse et contraignante.

Le dispositif de filtrage selon l'invention permet notamment de résoudre ce problème. En effet, dans l'invention, on propose une architecture particulière pour les ASIC présentés à la figure 3. Une des contraintes essentielles dans la conception d'une architecture de ces ASIC réside dans le fait qu'on ne souhaite plus ajouter de sources d'énergie externe nécessaire au fonctionnement des ASIC. L'architecture proposée offre donc une solution notamment pour que l'alimentation des ASIC soit directement fournie par des signaux continus circulant sur la ligne téléphonique.

L'invention concerne donc essentiellement un dispositif de filtrage basse fréquence installé sur une ligne téléphonique composée d'une première ligne de transmission et d'une deuxième ligne de transmission, ledit dispositif comportant notamment une partie active comprenant notamment un premier circuit intégré à application spécifique, ou ASIC, et un deuxième ASIC identiques, le premier ASIC étant disposé en série sur la première ligne de transmission entre un premier point de connexion, relié à une première broche de raccordement du premier ASIC, et un deuxième point de connexion, relié à une deuxième broche de raccordement du premier ASIC, de la première ligne de transmission, le deuxième ASIC étant disposé en série sur la deuxième ligne de transmission entre un troisième point de connexion, relié à la première broche de raccordement du deuxième ASIC, et un quatrième point de connexion, relié à la deuxième broche de raccordement du deuxième ASIC, de la deuxième ligne de transmission, caractérisé en ce que chaque ASIC comprend un circuit rectificateur actif, disposé en série entre la première broche de raccordement et la deuxième broche de raccordement de l'ASIC dans lequel il est compris, pour appliquer une différence de potentiel, dont le signe est indépendant du sens d'un courant circulant dans les lignes de transmission, aux bornes d'un circuit électronique qui réalise une admittance active et qui est compris dans chaque ASIC.

Dans un exemple particulier de réalisation, l'admittance active réalisée est une admittance du quatrième ordre.

Dans un exemple particulier de réalisation, chaque ASIC comporte un circuit de détection de décroché/raccroché, disposé en parallèle au circuit rectificateur actif, pour court-circuiter le circuit électronique réalisant une admittance active lorsque la ligne téléphonique est dans un état raccroché. Chaque ASIC comporte une troisième broche de raccordement qui peut alors être utilisée pour relier, par l'intermédiaire d'une résistance, les circuits de détection de décroché/raccroché de chaque ASIC.

Dans un exemple particulier de réalisation, chaque ASIC comporte un circuit d'adaptation d'impédance, relié à la première broche de raccordement, pour réaliser une adaptation d'impédance d'entrée du dispositif de filtrage basse fréquence à la ligne téléphonique. Chaque ASIC comporte une quatrième broche de raccordement qui peut alors être utilisée pour relier, par l'intermédiaire d'une résistance et d'une capacité disposées en série, les deux circuits d'adaptation d'impédance qui sont disposés dans chaque ASIC.

Dans un exemple particulier de réalisation, le circuit électronique réalisant l'admittance active comporte des amplificateurs opérationnels, caractérisés par une transconductance, qui sont directement alimentés par la ligne de transmission sur laquelle est disposé l'ASIC auquel ils appartiennent. Il peut également comporter un dispositif chuteur de tension pour que la tension appliquée aux bornes de chaque amplificateur opérationnel caractérisé par une transconductance soit inférieure à la tension d'alimentation de ces amplificateurs.

L'invention et ses différentes applications seront mieux comprises à la lecture de la description qui suit et à l'examen des figures qui l'accompagnent. Celles-ci ne sont présentées qu'à titre indicatif et nullement limitatif de l'invention. Les figures montrent :

- Figure 1, déjà décrite, une représentation de l'exploitation de la bande de fréquence en distribution ADSL ;
- Figure 2, déjà décrite, une illustration du principe de la séparation des signaux basse fréquence et haute fréquence sur une ligne ADSL ;
- Figure 3, déjà décrite, un schéma de principe d'un dispositif de filtrage basse fréquence 300, dans lequel on peut incorporer un circuit intégré à application spécifique du type de celui dont la structure est l'objet de l'invention ;
- Figure 4, un schéma de principe faisant apparaître les principaux circuits de l'architecture d'un ASIC utilisé dans le dispositif basse fréquence de l'invention ;
- Figure 5, une illustration de l'interconnexion des deux ASICS présents sur la ligne téléphonique ;
- Figure 6, un exemple de réalisation d'un circuit rectificateur actif appartenant à chaque ASIC;
- Figure 7, un exemple de réalisation d'une admittance active du premier ordre ;
- Figure 8, un exemple de réalisation d'un circuit électronique réalisant une admittance active du quatrième ordre et présent dans chaque ASIC ;
- Figure 9, un exemple de réalisation d'un premier type d'OTA intervenant dans l'admittance active du quatrième ordre ;
- Figure 10, un exemple de réalisation d'un deuxième type d'OTA intervenant dans l'admittance active du quatrième ordre ;
- Figure 11, un exemple de réalisation d'un circuit détecteur de décroché/raccroché intervenant dans le circuit intégré objet de l'invention ;
- Figure 12, un exemple de réalisation d'un circuit d'adaptation d'impédance intervenant dans le circuit intégré objet de l'invention ;
- Figure 13, une illustration schématique complète du circuit intégré objet de la présente invention ;
- Figure 14, une courbe représentant une impédance active, inverse de l'admittance active, en fonction de la fréquence des signaux traités.

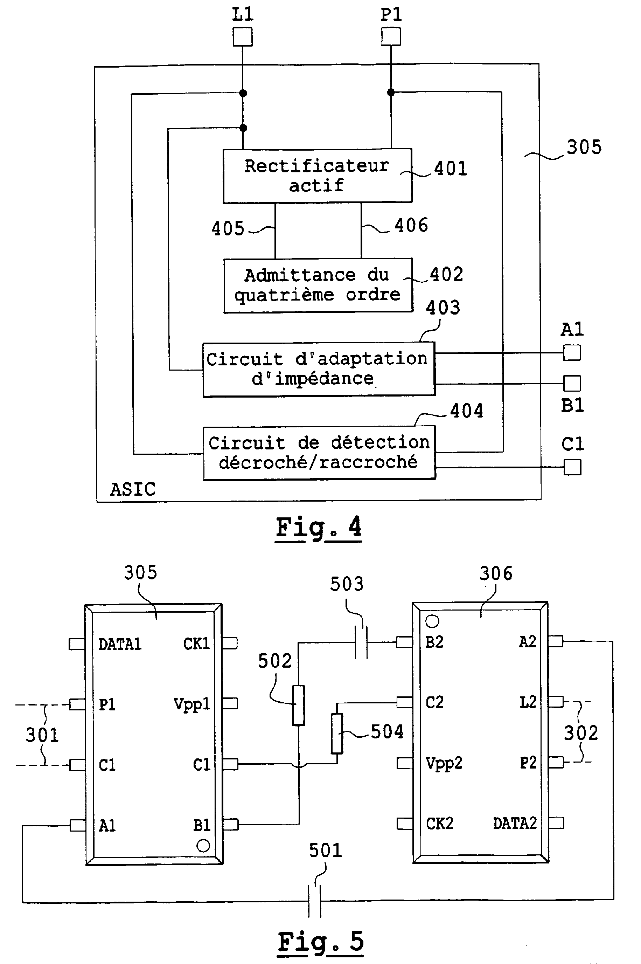

La figure 4 illustre de façon schématique les principaux circuits électroniques qui interviennent au sein de chaque ASIC incorporé dans le dispositif de filtrage basse fréquence objet de l'invention. L'ASIC représenté est l'ASIC 305 de la figure 3, qui est par ailleurs identique à l'ASIC 306. Cinq des huit broches, ou bornes, de raccordement de l'ASIC 305 sont représentées sur cette figure : A1, B1, C1, L1 et P1, ces deux dernières correspondant aux points de connexion 312 et 313 présents sur la figure 3. L'ASIC 305, qui est disposé en série sur la première ligne de transmission 301, voit donc circuler entre ses broches L1 et P1 et dans ses différents circuits les signaux transmis sur la première ligne de transmission 301.

Les broches L1 et P1 sont directement reliées à deux circuits électroniques distincts de l'ASIC 305 : un circuit dit rectificateur actif 401 et un circuit de détection d'opérations de décroché/raccroché 404. Ces deux circuits sont donc montés en parallèle, au sein de l'ASIC 305, sur la première ligne de transmission 301. Un troisième circuit électronique, qui est un circuit d'adaptation d'impédance 403, est relié à la broche L1. Un quatrième circuit électronique 402 distinct au sein de l'ASIC 305 est un circuit réalisant une admittance active qui, dans le cas exposé, est une admittance du quatrième ordre 402. Par admittance active, on désigne une admittance dont la valeur dépend de la fréquence des signaux reçus par le circuit électronique 402. Le quatrième circuit 402 est directement reliée au rectificateur actif 401 au moyen d'une première liaison 405 et d'une deuxième liaison 406.

Les broches A1 et B1 sont reliées au circuit d'adaptation d'impédance 403 ; la broche C1 est reliée au circuit de détection de décroché/raccroché 404. La figure 5 illustre la disposition des ASIC 305 et 306 sur les lignes de transmission 301 et 302, ainsi que les interconnexions entre ces deux ASIC. Sur cette figure, outre les cinq broches déjà représentées à la figure 4, on trouve également une broche DATA, une broche Vpp et une broche CK. Les références des broches de l'ASIC 305 sont terminées par l'indice 1, alors que celles des broches de l'ASIC 306 sont terminées par l'indice 2.

Sur cette figure, on illustre essentiellement le fait que les broches A1 et A2 sont reliées par une liaison comportant une capacité 501. Les broches B1 et B2 sont reliées par une liaison comportant une résistance 502 montée en série avec une capacité 503. Les broches C1 et C2 sont reliées par une liaison comportant une résistance 504. Le rôle de ces composants passifs sera précisé ultérieurement lors de la description d'autres figures où ils apparaissent.

La fonction de chacun des quatre circuits électroniques principaux de l'ASIC est la suivante :

- fonction du circuit rectificateur actif 401: lorsque la ligne téléphonique est dans un état décroché (ou "off hook"), un courant continu DC circule sur la ligne téléphonique L, mais dans un sens qui est a priori inconnu : on ne sait pas, par exemple pour l'ASIC 305, si le courant DC entre par la borne L1 et sort par la borne P1 ou bien si c'est le contraire. Or, comme on le verra ultérieurement, le circuit électronique 402 réalisant l'admittance du quatrième ordre comporte notamment des amplificateurs qui doivent être alimentés correctement. Le rôle du circuit rectificateur actif 401 est donc de créer deux potentiels V+ et V- indépendamment du sens du courant aux bornes L1 et P1. Par exemple, si le potentiel à la borne L, V(L), est supérieur au potentiel à la borne P, V(P), on aura alors V+=V(L) et V-=V(P), et si V(L), est inférieur à V(P), on aura alors V+=V(P) et V-=V(L).

- fonction du circuit réalisant l'admittance du quatrième ordre 402 : ce circuit permet d'obtenir, entre les bornes L et P de chaque ASIC, une admittance Y(p) de la forme :

$$Y(p) = 1/R0((1 + a1p + a2p^2 + a3p^3 + a4p^4)/( 1 + b1p + b2 p^2 + b3p^3 + b4p^4)) \text{ (équation 1)}$$

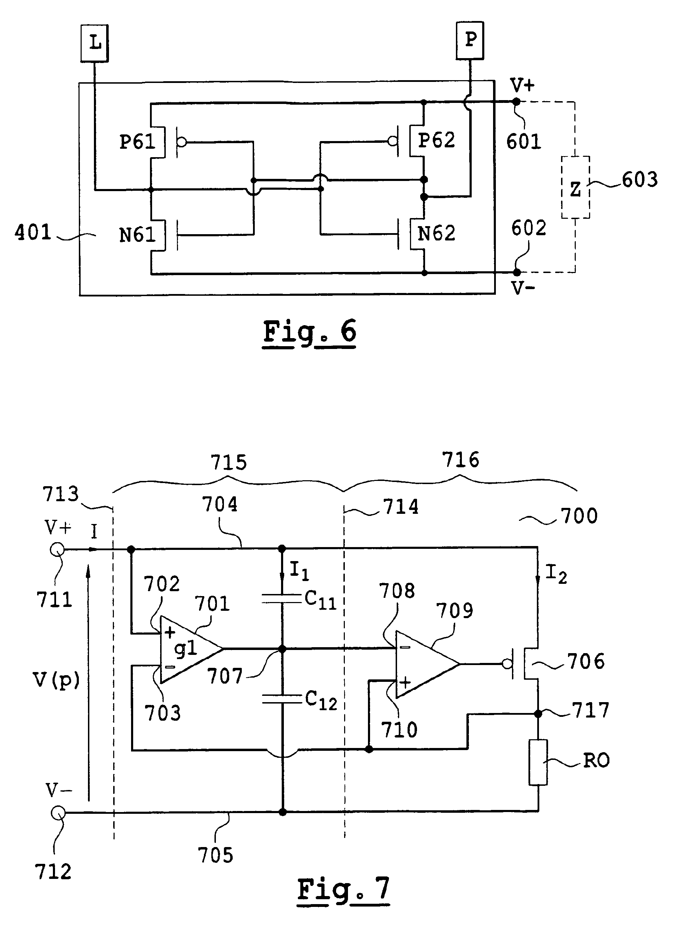

où p est la variable de Laplace liée à la pulsation w par la formule p=jw, où R0 correspond à la valeur de la résistance R0 apparaissant à la figure 7, et où les autres termes de l'équation sont des constantes qui seront déterminées ultérieurement. L'admittance est dite active car elle est fonction de la fréquence des signaux reçus par le circuit 402. On a ainsi :

$$I(p)=Y(p).V(p) \text{ (équation 2)}$$

où V(p) représente la tension alternative entre les bornes L et P d'un des deux ASIC 305 ou 306, et I(p) représente le courant circulant dans la ligne de transmission associée 301 ou 302.

Par ailleurs, le circuit dit d'admittance du quatrième ordre comporte un élément chuteur de tension assurer que les amplificateurs opérationnels du circuit 402 réalisant l'admittance du quatrième ordre seront toujours alimentés par un potentiel V+ et un potentiel V-, qui sont toujours, en valeur absolue, supérieurs à l'amplitude des tensions qui leur sont appliquées.

- fonction du circuit d'adaptation d'impédance 403 : ce circuit permet de changer la résistance d'entrée du dispositif de filtrage passe-bas 300 décrit à la figure 3. En particulier, en disposant une impédance du type de la résistance 502 et de la capacité 503 entre les bornes B1 et B2 des deux ASIC 305 et 306, on peut faire apparaître, en fonction des fréquences des différents signaux transmis aux ASIC, une impédance négative entre les bornes L1 et L2 des ASIC 305 et 306. En choisissant judicieusement la valeur de cette impédance négative, on réalise une adaptation de l'impédance d'entrée du dispositif de filtrage passe-bas 300 à la ligne téléphonique Li.
- fonction du circuit de détection de décroché/raccroché 404 : lorsque la ligne est raccroché (on hook en anglais), ce circuit permet d'obtenir une valeur de résistance faible, de l'ordre de 50 ohms, entre les bornes L et P de chaque ASIC. L'admittance du quatrième ordre est alors court-circuitée. Dès que la ligne est décrochée (off hook en anglais), un courant supérieur à une valeur seuil préalablement déterminée apparaît sur la ligne téléphonique, et le circuit de détection de décroché/raccroché 404 permet d'obtenir une impédance de valeur très élevée.

Les fonctionnements des différents circuits électroniques présents dans l'ASIC objet de l'invention sont à présent plus détaillés dans le cadre d'exemples particuliers de réalisation de ces circuits.

Un exemple de réalisation du circuit rectificateur actif 401 est représenté à la figure 6. Sur cette figure, on retrouve les bornes L et P d'un des ASIC 305 ou 306. Le circuit 401 comporte quatre transistors à effet de champ (FET) dont deux à canal N, N61 et N62, et deux à canal P, P61 et P62. La borne L est directement reliée à la source du FET P61, au drain du FET N61, et aux grilles des FET P62 et N62. La borne P est directement reliée à la source du FET P62, au drain du FET N62, et aux grilles des FET P61 et N61. Le circuit 401 présente deux extrémités qui sont référencées 601 et 602 ; il permet d'obtenir au point 601 un potentiel V+ et au point 602 un potentiel V- inférieur au potentiel V+, et ceci indépendamment des valeurs relatives des potentiels V(L) et V(P). Entre les extrémités 601 et 602, on peut disposer une impédance 603 de valeur Z. Dans la réalisation de l'ASIC intervenant dans l'objet de l'invention, c'est l'admittance du quatrième ordre qui est disposée entre les extrémités 601 et 602.

Un exemple de réalisation du circuit 402 réalisant une admittance du quatrième ordre est illustré au moyen des figures 7, 8 et 9. Le circuit 402 réalisant une admittance du quatrième ordre est une source de courant commandée en tension. La tension qui commande cette source de courant est la différence de potentiel entre la borne L et la borne P de chaque ASIC, que l'on retrouve entre les extrémités 601 et 602 du circuit 401. Des éléments actifs sont utilisés dans ce circuit : ce sont des OTA (pour Operational Transconductance Amplifier en anglais), c'est à dire des amplificateurs opérationnels caractérisés par leur transconductance. Chaque OTA transforme une différence de potentiel $\Delta V(t)$ à ses bornes en un courant de sortie i(t) selon l'équation suivante : $i(t)=g_m. \Delta V(t)$ (équation 3) où $g_m$ est la transconductance de l'OTA considéré.

Avant de s'intéresser à la structure du circuit réalisant une admittance du quatrième ordre, il est préférable,

par souci de simplification de l'exposé, de représenter un circuit réalisant une admittance du premier ordre, tel que le circuit 700 représenté à la figure 7.

Sur cette figure, le circuit 700 présente une entrée 711 portée au potentiel V+ et une sortie 712 portée au potentiel V-. Un OTA 701 est caractérisé par une transconductance g1. Il possède une première entrée 702 et une deuxième entrée 703 dont le potentiel est moins élevé que le potentiel de la première entrée 702. Une liaison conductrice 704, qui est reliée à l'entrée 711, est connectée d'une part à la première entrée 702 de l'OTA 701, à une capacité C11 et à la source d'un transistor à effet de champ à canal P 706. Le drain de ce FET 206 est relié par l'intermédiaire d'une résistance R0 à une liaison conductrice 705 qui est reliée à la sortie 712. La liaison conductrice 705 est par ailleurs reliée à une capacité C12, qui est elle-même connectée à la capacité C11.

La sortie de l'OTA 701 est reliée à un point de connexion 707 situé sur une liaison reliant les deux capacités C11 et C12. Une entrée positive 708 d'un amplificateur opérationnel 709 est également reliée au point de connexion 707. L'entrée négative 710 de l'amplificateur opérationnel 709 est connectée à une liaison reliant la deuxième entrée 703 de l'OTA 701 à un point de connexion 717 situé entre le drain du FET 706 et la résistance R0. Enfin, la sortie de l'amplificateur opérationnel 709 est reliée à la grille du FET 706.

L'amplificateur opérationnel 709 a un gain très élevé.

En considérant les équations suivantes

$$g1=C1/b1 \qquad \text{(équation 4)}$$

$$C11=a1.C1/b1 \qquad \text{(équation 5)}$$

$$C12=(1-a1/b1).C1 \qquad \text{(équation 6)},$$

Ou a1, b1 et C1 sont des constantes qui seront déterminées ultérieurement, et en choisissant C1 de telle sorte qu'un courant I1, circulant entre la liaison 704 et la capacité C11, soit négligeable devant I2, qui est le courant parvenant à la source du FET 706, on obtient l'admittance du circuit 700 suivante :

$$Y(p)=I(p)/V(p)=(1+a1p)/(R0.(1+b1p)) \qquad \text{(équation 16)}$$

où I(p) est le courant au point 711 et V(p) est la différence de potentiel entre les points 711 et 712.

Sur la figure 7, deux traits en pointillés 713 et 714 définissent dans l'espace les séparant, une cellule de base 715. Elle comporte notamment l'OTA 701 et les deux capacités C11 et C12. La partie du circuit 700 située à droite du trait en pointillé 714 constitue une cellule 716 dite de terminaison. La cellule de terminaison 716 comporte notamment l'amplificateur opérationnel 709, le FET 706 et la résistance R0.

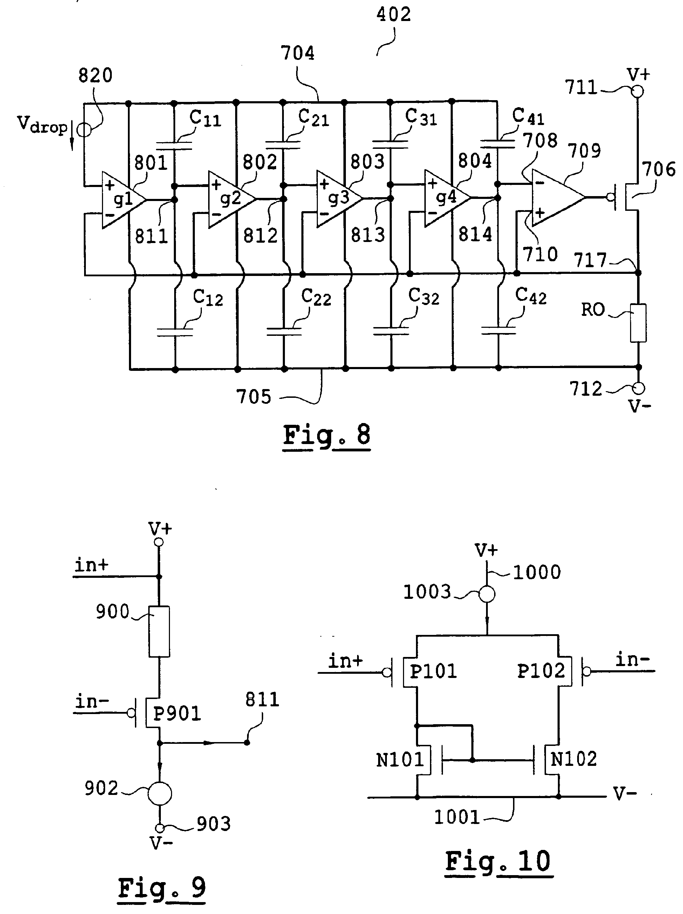

Le circuit 402 réalisant une admittance du quatrième ordre est représenté à la figure 8. Ce circuit est en fait constitué de la juxtaposition de quatre cellules de base 715, puis de la cellule de terminaison 716.

Chaque cellule de base comporte donc un OTA 80X caractérisé par une transconductance gX, correspondant à l'OTA 701 de la figure 7, une première capacité CX1, correspondant à la capacité C11 de la figure 7, une deuxième capacité CX2, correspondant à la capacité C12 de la figure 7, et un point de connexion 81 X correspondant au point de connexion 707 de la figure 7, où X, qui varie de 1 à 4, désigne le numéro de la cellule de base à laquelle un élément appartient. La première cellule de base diffère légèrement des trois suivantes dans la mesure où elle possède un élément chuteur de tension 820 destiné à abaisser la tension des signaux alternatifs qui sont appliqués entre l'entrée 711 et la sortie 712 du circuit 402. On s'assure ainsi que les différents amplificateurs seront toujours soumis à un potentiel V+ et un potentiel V-, qui seront toujours, en valeur absolue, supérieurs à l'amplitude des tensions qui sont appliqués à ces amplificateurs. Chaque OTA est directement relié, au niveau de sa borne d'alimentation positive, respectivement négative, à la liaison 704 portée au potentiel V+, respectivement à la liaison 705 portée au potentiel V-.

Pour obtenir une admittance telle qu'exprimée dans l'équation 1, à savoir :

$$Y(p)=1/R0((1+a1p+a2p^2+a3p^3+a4p^4)/(1+b1p+b2p^2+b3p^3+b4p^4)) \quad ,$$

on fixe les différentes valeurs des capacités et des transconductances de la façon suivante :

$$g1=C1/b1 \qquad \text{(équation 4)}$$

$$C11=a1.C1/b1 \qquad \text{(équation 5)}$$

$$C12=(1-a1/b1).C1 \qquad \text{(équation 6),}$$

$$g2=b1C2/b2 \qquad \text{(équation 7)}$$

$$C21=a2.C2/b2 \qquad \text{(équation 8)}$$

$$C22=(1-a2/b2).C2 \qquad \text{(équation 9),}$$

$$g3=b2C3/b3 \qquad \text{(équation 10)}$$

$$C31=a3.C3/b3 \qquad \text{(équation 11)}$$

$$C32=(1-a3/b3).C3 \qquad \text{(équation 12),}$$

$$g4=b3C4/b4 \qquad \text{(équation 13)}$$

$$C41=a4.C4/b4 \qquad \text{(équation 14)}$$

$$C42=(1-a4/b4).C4 \qquad \text{(équation 15),}$$

où C1, C2, C3 et C4 sont des constantes.

Dans un exemple particulier de réalisation, on choisit les valeurs suivantes pour les coefficients :

1/R0=0.2
a 1=1.64e-4
a2=1.54e-8
a3=8.2e-15
a4=3.56e-19
b1=1.9e-3
b2=2.6e-7
b3=3.9e-12
b4=3.56e-19

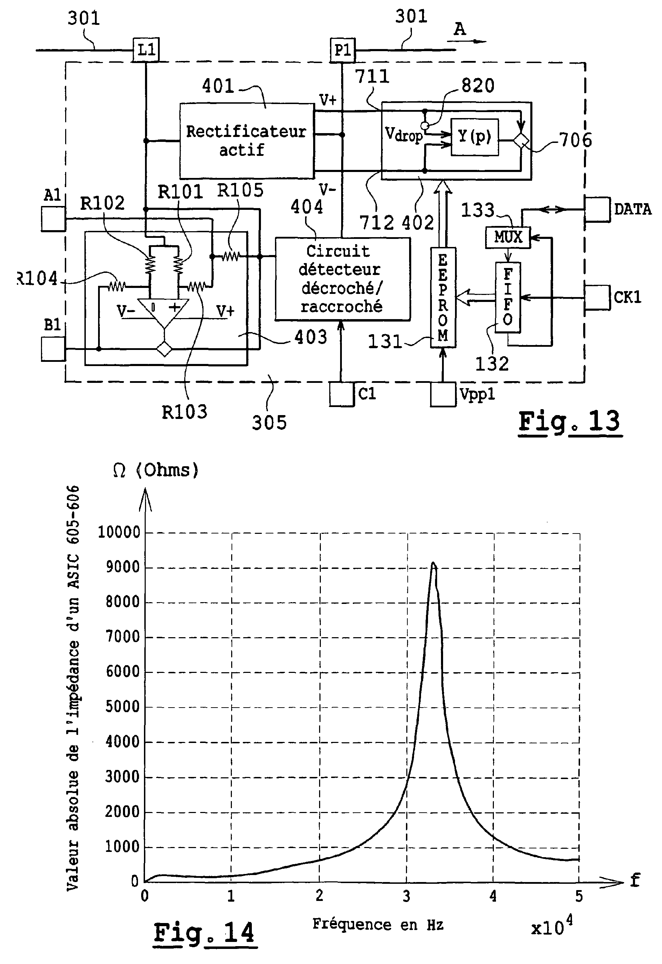

De telles valeurs permettent d'obtenir une impédance active, inverse de l'admittance active, telle que représentée sur la courbe de la figure 14. Sur cette courbe, on peut observer que l'impédance est quasiment nulle pour des fréquences voisines de 0 et pour les fréquences supérieures à 200 kHz, et qu'elle présente, en valeur absolue, un maximum pour des valeurs de fréquences voisines de 30 kHz. Le niveau de réjection sera ainsi maximal pour les fréquences voisines de 30 kHz, la séparation des signaux basse fréquence et haute fréquence pouvant ainsi être assurée. Typiquement, la valeur maximale de l'impédance est voisine de 10 kiloOhms

La figure 9 illustre un exemple de réalisation de l'OTA 801 associé à l'élément chuteur de tension 820. Sur cette figure, l'entrée positive in+ de l'amplificateur 801 est directement reliée à la grille d'un transistor à effet de champ à canal P, P901, la source de ce FET étant reliée à l'entrée négative de l'amplificateur 801. Le drain du FET P901 constitue la sortie de l'amplificateur 801, c'est à dire qu'elle aboutit au point de connexion 811. Une liaison 903, portée au potentiel V-, aboutit également au drain du FET P901. L'élément chuteur de tension 820 combine ici la tension aux bornes de la résistance 900 et la tension grille-source du transistor P901. Lorsqu'une tension est appliquée à l'entrée d'un amplificateur 801, c'est à dire entre in+ et in-, l'amplificateur se comporte comme une source de courant 902 commandée en tension. La source de courant 902 est réalisée de manière à contrôler la tension Vdrop 820 indépendamment de la température. La transconductance g1 est, en première approximation, inversement proportionnelle à la valeur de la résistance 900.

La figure 10 illustre un exemple de réalisation des OTA 802, 803 et 804, qui sont identiques. Sur cette figure, l'entrée positive in+ de l'amplificateur 80X est directement reliée à la grille d'un premier transistor à effet de champ à canal P, P101, et l'entrée négative in- de l'amplificateur 80X est directement reliée à la grille d'un deuxième FET à canal P, P102. Les sources de ces deux FET sont reliées à une liaison conductrice 1000 portée au potentiel V+. Le drain du FET P102 est relié au drain d'un FET à canal N, N102. La grille de ce FET N102 est reliée d'une part à la grille d'un autre FET à canal N, N101, et aux drains des FET P101 et N101. Les sources des FET N101 et N102 sont reliées à une liaison qui est portée au potentiel V-. Lorsqu'une tension est appliquée à l'entrée d'un amplificateur 80X, c'est à dire entre in+ et in-, l'amplificateur se comporte comme une source de courant 1003 commandée en tension. La source de courant 902 comporte notamment une résistance interne non représentée, qui est un clone de la résistance interne Rin de la figure 9, qui permet de définir le courant débité, et ainsi de régler la transconductance de chaque OTA. La transconductance $g_x$ est aussi dépendante des caractéristiques des transistors.

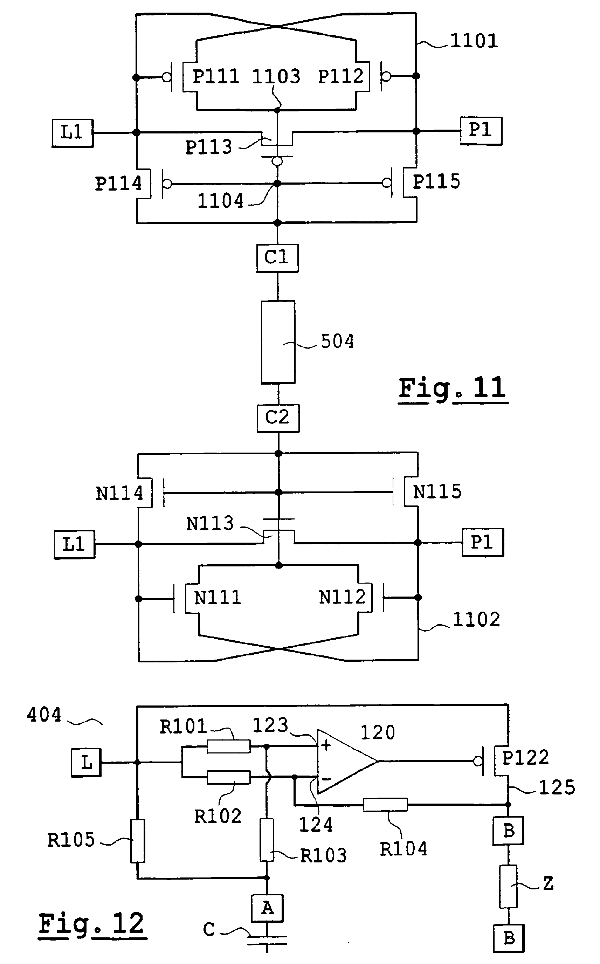

La figure 11 est un exemple de réalisation du circuit de détection de décroché/raccroché 404. Sur cette figure, on a uniquement représenté les éléments intervenant pour un cas de polarisation du circuit, qui correspond à un sens déterminé du courant dans les lignes de transmission 301 et 302. La figure 11 est composée d'un premier bloc élémentaires 1101, présent dans l'ASIC 305, et d'un deuxième bloc élémentaires 1102, présent dans l'ASIC 306.

Le premier bloc élémentaire 1101 comporte cinq transistors à effet de champ à canal P. La borne L1 est directement reliée à la source d'un FET P112, d'un FET P114, d'un FET P113 et à la grille d'un FET P111. La borne P1 est directement reliée à la source du FET P111, d'un FET P115, au drain du FET P113 et à la grille du FET P112. Les drains des FET P111 et P112 sont reliés à un point de connexion 1103 qui est par ailleurs relié à un point de connexion 1104. Le point de connexion 1104 est par ailleurs relié à la grille des FET P113, P114 et P115, ainsi qu'à la borne C1. Enfin, la borne C1 est directement reliée aux drains des FET P114 et P115. Le premier bloc élémentaire est, dans la pratique, doublé : un bloc élémentaire complémentaire non représenté, appartenant au même ASIC, est monté en parallèle au bloc 1101 entre les bornes L1 et P1. Ce bloc complémentaire intervient lorsque le sens du courant, dans les lignes de transmission 301 et 302, est inversé par rapport à celui qui a été déterminé plus haut. Ces deux blocs sont identiques, à la différence que tous les FET à canal P du bloc 1101 sont remplacés par des FET à canal N. L'association de ces deux blocs constitue le circuit de détection de décroché/raccroché représenté à la figure 4.

La borne C1 est reliée à la borne C2 via la résistance 504, typiquement de valeur 4,7 mégaOhms. Le bloc 1102 a une structure symétrique à celle du bloc 1101 par rapport à la résistance 504 les séparant, à la différence que tous les FET à canal P ont été remplacés par des FET à canal N. Dans l'ASIC 306 le bloc 1102 est complété, afin de constituer le circuit de détection de décroché/raccroché de l'ASIC 306, par un autre bloc complémentaire non représenté, monté en parallèle au deuxième bloc élémentaire 1102 entre les bornes L2 et P2, de même structure que le bloc 1102, à la différence que les FET à canal N ont été remplacés par des FET à canal P.

Une telle architecture permet de détecter les passages d'un mode décroché à un mode raccroché en comparant un courant circulant entre une borne L et une borne P d'un des ASIC 305 ou 306 et le courant circulant dans la résistance 504.

La figure 12 donne un exemple de réalisation du circuit d'adaptation d'impédance 403. Ce circuit comporte notamment cinq résistances : R101, R102, R103, R104 et R105, un amplificateur opérationnel 120 et un FET à canal P, P122. La broche L est raccordée à la broche A par l'intermédiaire de la résistance R105, à une entrée positive 123 de l'amplificateur 120 par l'intermédiaire de la résistance R101, à une entrée négative 124 de l'amplificateur 120 par l'intermédiaire de la résistance R102, et à la source du FET P122. L'entrée négative 124 de l'amplificateur 120 est connectée, par l'intermédiaire de la résistance R104 à une liaison 125 reliant le drain du FET P122 et la borne B. L'entrée positive 124 de l'amplificateur 120 est connectée, par l'intermédiaire de la résistance R103 à la borne B. La sortie de l'amplificateur 120 est reliée à la grille du FET P122.

Si on considère que les deux bornes B des ASIC 305 et 306 sont reliées par l'intermédiaire d'une impédance de valeur Z, et que les deux bornes A des ASIC sont reliées par l'intermédiaire d'une capacité de valeur C, on obtient une impédance d'entrée Zin qui, vue de la borne L, a l'expression suivante :

$$\text{Zin(p)}=Z((R1+R3).C.p+1+(R1+R3)/R5)/((R3-R4R1/R2).Cp+1+(R1+R3)/R5)$$

$$(\text{équation 17})$$

où Rx correspond à R10x, x pouvant varier de 1 à 5, par soucis de simplification de l'équation 17.

En adoptant les valeurs suivantes de résistance :

R101 =150 kiloOhms ;
R102=100 kiloOhms ;
R103=50 kiloOhms ;
R104=83 kiloOhms ;
R105=450 kiloOhms ;

L'équation 17 devient : Zin(p)=-2,68Z.((pT+1)/(pT-2,68)),
où T est une constante de temps telle que T=14000C.

Ainsi, pour des fréquences supérieures à 1/T, le circuit d'adaptation d'impédance 404 se comporte comme une impédance négative avec un gain de -2,68. Pour des fréquences plus petites que 1/T, l'impédance est simplement égale à Z.

La figure 13 reprend les principaux circuits qui viennent d'être décrits. Elle comporte également un module de mémoire de type EEPROM 131, une mémoire FIFO 132 et un multiplexeur 133. Ces différents éléments sont contenus dans chaque ASIC 305 et 306. Le multiplexeur 133 est connecté à la borne DATA, la borne CK permet d'envoyer un signal d'horloge à la mémoire FIFO 132, et la borne Vpp est connectée à la mémoire EEPROM 131. Le multiplexeur 133 peut recevoir des données depuis le module de mémoire FIFO 132 et lui communiquer des données sous forme multiplexée. La mémoire FIFO peut échanger des données avec la mémoire EEPROM 131. Un tel système permet de disposer de 16 bits pour contrôler le processus de programmation des ASIC.

Un premier bit sert à déterminer si les variables à programmer dans l'ASIC sont définies par le contenu de la mémoire FIFO 132 ou par le contenu de l'EEPROM 131. Un deuxième bit sert à déterminer si l'admittance à réaliser correspond à la norme européenne ou à la norme américaine. 3 bits sont réservés pour le paramétrage de la tension Vdrop, ce qui revient à régler la résistance R900 de la figure 9, 6 bits sont réservés pour le paramétrage des différentes transconductances, ce qui revient à régler la valeur des résistances Rin présentes dans les sources de courant des figures 9 et 10, et 5 bits sont réservés pour le paramétrage de la résistance R0.

Les ajustements des différentes résistances R900, Rin et R0 se font, de façon connue, par l'utilisation d'un multiplexeur analogique associé avec un réseau de résistances.

**Revendications**

1. Dispositif de filtrage basse fréquence (300) installé sur une ligne (Li) téléphonique composée d'une première ligne de transmission (301) et d'une deuxième ligne de transmission (302), ledit dispositif comportant notamment une partie active comprenant notamment un premier circuit intégré à application spécifique (305), ou ASIC, et un deuxième ASIC (306) identiques, le premier ASIC (305) étant disposé en série sur la première ligne de transmission (301) entre un premier point de connexion (312), relié à une première broche (L1) de raccordement du premier ASIC (305), et un deuxième point de connexion (313), relié à une deuxième broche (P1) de raccordement du premier ASIC (305), de la première ligne de transmission (301), le deuxième ASIC (306) étant disposé en série sur la deuxième ligne de transmission (302) entre un troisième point de connexion (314), relié à la première broche de raccordement (L2) du deuxième ASIC (306), et un quatrième point de connexion (315), relié à la deuxième broche de raccordement (P2) du deuxième ASIC (306), de la deuxième ligne de transmission (302), **caractérisé en ce que** chaque ASIC (305 ;306) comprend un circuit rectificateur actif (401), disposé en série entre la première broche de raccordement (L1 ;L2) et la deuxième broche de raccordement (P1 ;P2) de l'ASIC (305 ;306) dans lequel il est compris, pour appliquer une différence de potentiel, dont le signe est indépendant du sens d'un courant circulant dans les lignes de transmission (301 ;302), aux bornes d'un circuit électronique (402) qui réalise une admittance active et qui est compris dans chaque ASIC (305 ; 306).

**2.** Dispositif de filtrage basse fréquence (300) selon la revendication précédente, **caractérisé en ce que** l'admittance réalisée est une admittance du quatrième ordre.

**3.** Dispositif de filtrage basse fréquence (300) selon l'une des revendications précédentes, **caractérisé en ce que** chaque ASIC (305 ;306) comporte un circuit de détection de décroché/raccroché (404), disposé en parallèle au circuit rectificateur actif (401), pour court-circuiter le circuit électronique (402) réalisant une admittance active lorsque la ligne téléphonique (Li) est dans un état raccroché.

**4.** Dispositif de filtrage basse fréquence (300) selon la revendication précédente, **caractérisé en ce que** chaque ASIC (305 ;306) comporte une troisième broche de raccordement (C1 ;C2) utilisée pour relier, par l'intermédiaire d'une résistance (504), les circuits de détection de décroché/raccroché (404) de chaque ASIC (305 ;306).

**5.** Dispositif de filtrage basse fréquence (300) selon l'une des revendications précédentes, **caractérisé en ce que** chaque ASIC (305 ;306) comporte un circuit d'adaptation d'impédance (403), relié à la première broche de raccordement (L1 ;L2), pour réaliser une adaptation d'impédance d'entrée du dispositif de filtrage basse fréquence (300) à la ligne téléphonique (Li).

**6.** Dispositif de filtrage basse fréquence (300) selon la revendication précédente, **caractérisé en ce que** chaque ASIC (305 ;306) comporte une quatrième broche de raccordement (B1 ;B2) utilisée pour relier, par l'intermédiaire d'une résistance (502) et d'une capacité (503) disposées en série, les deux circuits d'adaptation d'impédance (403) qui sont disposés dans chaque ASIC (305 ;306).

**7.** Dispositif de filtrage basse fréquence (300) selon l'une des revendications précédentes, **caractérisé en ce que** le circuit électronique (402) réalisant l'admittance active comporte des amplificateurs opérationnels (801 ;802 ;803 ; 804) **caractérisés par** une transconductance (g1 ;g2 ;g3 ;g4) qui sont directement alimentés par la ligne de transmission (301 ;302) sur laquelle est disposé l'ASIC (305 ;306) auquel ils appartiennent.

**8.** Dispositif de filtrage basse fréquence (300) selon la revendication précédente, **caractérisé en ce que** le circuit électronique (403) réalisant l'admittance active comporte un dispositif chuteur de tension (820) pour que la tension appliquée aux bornes de chaque amplificateur opérationnel (801 ;802 ;803 ;804) **caractérisé par** une transconductance soit inférieure à la tension d'alimentation de ces amplificateurs (801 ;802 ;803 ;804).

**Claims**

**1.** A low frequency filtering device (300) installed on a telephone line (Li) comprised of a first transmission line (301) and a second transmission line (302), the said device notably comprising an active part, notably including a first integrated circuit with a specific application (305), or ASIC, and a second identical ASIC (306), the first ASIC (305) being placed in tandem on the first transmission line (301) between a first connection point (312), linked to a first connecting pin (L1) of the first ASIC (305), and a second connection point (313), linked to a second connecting pin (P1) of the first ASIC (305), of the first transmission line (301), the second ASIC (306) being placed in tandem on a second transmission line (302) between a third connection point (314), linked to a first connecting pin (L2) of the second ASIC (306), and a fourth connection point (315), linked to a second connecting pin (P2) of the second ASIC (306), of the second transmission line (302), **characterised in that** each ASIC (305; 306) includes an active rectifier circuit (401), placed in tandem between the first connecting pin (L1; L2) and the second connecting pin (P1; P2) of the ASIC (305; 306) in which it is included, in order to apply a difference in potential, the sign of which being independent from the direction of a circulating current in the transmission lines (301; 302), on the terminals of an electronic circuit (402) which creates an active admittance and which is included in each ASIC (305; 306).

**2.** A low frequency filtering device (300) according to the previous claim, **characterised in that** the admittance created is an admittance of the fourth order.

**3.** A low frequency filtering device (300) according to one of the previous claims, **characterised in that** each ASIC (305; 306) comprises an on/off-the-hook sensor circuit (404), placed parallel to the active rectifier circuit (401), in order to short-circuit the electronic circuit (402) creating an active admittance when the telephone line (Li) is in an on-the-hook status.

**4.** A low frequency filtering device (300) according to the previous claim, **characterised in that** each ASIC (305; 306) comprises a third connecting pin (C1; C2), used to link up, via a resistance (504), the on/off-the-hook sensor circuits (404) of each ASIC (305; 306).

5. A low frequency filtering device (300) according to one of the previous claims, **characterised in that** each ASIC (305; 306) comprises an impedance adaptation circuit (403), linked to the first connecting pin (L1; L2), in order to create an entry impedance adaptation of the low frequency filtering device (300) on the telephone line (Li).

6. A low frequency filtering device (300) according to the previous claim, **characterised in that** each ASIC (305; 306) comprises a fourth connecting pin (B1; B2) used to link up, via a resistance (502) and a capacity (503) placed in tandem, the two impedance adaptation circuits (403) placed in each ASIC (305; 306).

7. A low frequency filtering device (300) according to one of the previous claims, **characterised in that** the electronic circuit (402) creating the active admittance comprises operational amplifiers (801; 802; 803; 804), **characterised by** a transconductance (g1; g2; g3; g4) directly powered by the transmission line (301; 302) on which is placed the ASIC (305; 306) to which it belongs.

8. A low frequency filtering device (300) according to the previous claim, **characterised in that** the electronic circuit (403) creating the active admittance comprises a drop-in-voltage device (820) for the voltage applied to the terminals of each operational amplifier (801; 802; 803; 804), **characterised by** a transconductance being lower than the voltage supply of such amplifiers (801; 802; 803; 804).

**Patentansprüche**

1. Vorrichtung zur Niederfrequenzfilterung (300), die in eine Telefonleitung (Li) installiert ist, die aus einer ersten Übertragungsleitung (301) und einer zweiten Übertragungsleitung (302) besteht, wobei die besagte Vorrichtung speziell einen aktiven Abschnitt mit speziell einem ersten anwendungsspezifischen integrierten Schaltkreis (305), oder ASIC enthält, und einen zweiten identischen ASIC (306), wobei der erste ASIC (305) in Reihe in der ersten Übertragungsleitung (301) zwischen einem ersten Anschlusspunkt (312), der mit einem ersten Anschluss-Pin (L1) des ersten ASIC (305) und einem zweiten Anschlusspunkt (313), der mit einem zweiten Anschluss-Pin (P1) des ersten ASIC (305) der ersten Übertragungsleitung (301) geschaltet ist, wobei der zweite ASIC (306) in Reihe in der zweiten Übertragungsleitung (302) zwischen einem dritten Anschlusspunkt (314), der mit einem ersten Anschluss-Pin (L2) des zweiten ASIC (306) und einem vierten Anschlusspunkt (315), der mit einem zweiten Anschluss-Pin (P2) des zweiten ASIC (306) der zweiten Übertragungsleitung (302) geschaltet ist, **dadurch gekennzeichnet, dass** jeder ASIC (305; 306) einen aktiven Gleichrichterkreis (401) enthält, der in Reihe zwischen dem ersten Anschluss-Pin (L1; L2) und dem zweiten Anschluss-Pin (P1; P2) des ASIC (305; 306) angebracht ist, in dem er enthalten ist, um eine Potentialdifferenz anzuwenden, dessen Vorzeichen unabhängig von der Richtung eines Stromes ist, der durch die Übertragungsleitungen (301; 302) fließt, an den Klemmen eines Elektronikkreislaufs (402), der eine aktive Admittanz erzeugt und der in jedem ASIC (305; 306) enthalten ist.

2. Vorrichtung zur Niederfrequenzfilterung (300) nach dem vorherigen Anspruch, **dadurch gekennzeichnet, dass** die erzeugte Admittanz eine Admittanz der vierten Ordnung ist.

3. Vorrichtung zur Niederfrequenzfilterung (300) nach einem der vorherigen Ansprüche, **dadurch gekennzeichnet, dass** jeder ASIC (305; 306) eine Schaltung zur Erfassung des Zustandes abgehoben/ aufgelegt (404) enthält, der parallel zum aktiven Gleichrichterkreis (401) geschaltet ist, um den Elektronikkreislauf (402) zu überbrücken, der eine aktive Admittanz erzeugt, wenn sich die Telefonleitung (Li) im aufgelegten Zustand befindet.

4. Vorrichtung zur Niederfrequenzfilterung (300) nach dem vorherigen Anspruch, **dadurch gekennzeichnet, dass** jeder ASIC (305; 306) einen dritten Anschluss-Pin (C1; C2) enthält, der verwendet wird, um die Schaltungen zur Erfassung des Zustandes abgehoben/ aufgelegt (404) jedes ASIC (305; 306) über einen Widerstand (504) zu verbinden.

5. Vorrichtung zur Niederfrequenzfilterung (300) nach einem der vorherigen Ansprüche, **dadurch gekennzeichnet, dass** jeder ASIC (305; 306) eine Schaltung zur Impedanzanpassung (403) enthält, der mit dem ersten Anschluss-Pin (L1; L2) verbunden ist, um die Eingangsimpedanz an der Vorrichtung zur Niederfrequenzfilterung (300) in der Telefonleitung (Li) anzupassen.

**6.** Vorrichtung zur Niederfrequenzfilterung (300) nach dem vorherigen Anspruch, **dadurch gekennzeichnet, dass** jeder ASIC (305; 306) einen vierten Anschluss-Pin (B1; B2) enthält, der verwendet wird, um die beiden Schaltungen zur Impedanzanpassung (403), die in jedem ASIC (305; 306) enthalten sind, durch einen in Reihe geschalteten Widerstand (502) und eine Kapazität (503) miteinander zu verbinden.

**7.** Vorrichtung zur Niederfrequenzfilterung (300) nach einem der vorherigen Ansprüche, **dadurch gekennzeichnet, dass** der Elektronikkreislauf (402), der die aktive Admittanz erzeugt, operationelle Verstärker (801; 802; 803; 804) enthält, die durch einen Gegenwirkleitwert (g1; g2; g3; g4) **gekennzeichnet** sind, und die direkt von der Übertragungsleitung (301; 302) versorgt werden, auf der der ASIC (305; 306) angebracht ist, dem sie angehören.

**8.** Vorrichtung zur Niederfrequenzfilterung (300) nach dem vorherigen Anspruch, **dadurch gekennzeichnet, dass** der Elektronikkreislauf (403), der die aktive Admittanz erzeugt, eine Spannungsabfallvorrichtung (820) enthält, damit die an den Klemmen eines jeden operationellen und durch einen Gegenwirkleitwert **gekennzeichnet**en Verstärkers (801; 802; 803; 804) anliegende Spannung geringer ist, als die Versorgungsspannung dieser Verstärker (801; 802; 803; 804).

## Fig. 1

Spectre
de
puissance

100

102

103

104    105

107

101

Spectre
vocal

4khz   4,2khz

4,3khz

106        106

1,1Mhz

Echelle des
frequences

## Fig. 2

208   207   201        202   205   206

210                          204

HF

200

Splitter        Li        Splitter

D
S
L
A
M

Internet

BF

203

211

209

## Fig. 3

300
301   303              305        313

312   ASIC              311

Li    310                          A

314

315

302   304     Fig. 3     306

L1 P1

305

Rectificateur actif 401

405 406

Admittance du quatrième ordre 402

403

Circuit d'adaptation d'impédance

A1

B1

404

Circuit de détection décroché/raccroché

C1

ASIC

**Fig. 4**

305 503 306

502

DATA1 CK1

P1 Vpp1

301 504

C1 Vpp2

A1 B1

B2 A2

C2 L2

302

CK2 DATA2

501

**Fig. 5**

**Fig. 6**

**Fig. 7**

Fig. 8

Fig. 9

Fig. 10

_Fig. 11_

_Fig. 12_

**Fig. 13**

Ω (Ohms)

Valeur absolue de l'impédance d'un ASIC 605-606

**Fig. 14**

Fréquence en Hz

x10⁴

**EP 1 493 228 B1**

## RÉFÉRENCES CITÉES DANS LA DESCRIPTION

**Documents brevets cités dans la description**

- EP 0942578 A2